# EUROPEAN PATENT APPLICATION

(11) **EP 1 603 129 A1**
(43) Date of publication of application: **07.12.2005**
(21) Application number: 03712681.0
(22) Date of filing: 13.03.2003
(51) Int. Cl.: G11B 7/26, G11B 7/24, C23C 14/34

(54) **SILVER ALLOY SPUTTERING TARGET FOR FORMING REFLECTIVE LAYER OF OPTICAL RECORDING MEDIUM**

(71) Applicant: MITSUBISHI MATERIALS CORPORATION, Chiyoda-ku, Tokyo 100-8117 (JP)
(72) Inventor: MISHIMA, Akifumi c/o Mitsubishi Materials Corp., Sanda-shi, Hyogo 669-1339 (JP)
(74) Representative: Gille Hrabal Struck Neidlein Prop Roos
(86) International application number: PCT/JP2003/003006
(87) International publication number: WO 2004/081929

(57) **Abstract**

A silver alloy sputtering target for forming Ag alloy reflective layer of optical recording media such as magneto-optical recording disks (MD, MO) and optical recording disks (CD-RW, DVD-RAM) is provided. The sputtering target is made of (1) a silver alloy having a composition of 0.5 to 3% by mass of Cu and 0.1 to 3% by mass in total of one or more elements selected from among Dy, La, Nd, Tb and Gd, with the remainder consisting of Ag; (2) a silver alloy having a composition of 0.5 to 3% by mass of Cu and 0.005 to 0.05% by mass in total of one or more elements selected from among Ca, Be and Si, with the remainder consisting of Ag; or (3) a silver alloy having composition of 0.5 to 3% by mass of Cu, 0.1 to 3% by mass in total of one or more elements selected from among Dy, La, Nd, Tb and Gd and 0.005 to 0.05% by mass in total of one or more elements selected from among Ca, Be and Si, with the remainder consisting of Ag.

## Description

### TECHNICAL FIELD

The present invention relates to a silver alloy sputtering target for forming, by the sputtering process, a semi-transparent reflective layer or a reflective layer (hereinafter collectively referred to as the reflective layer) that constitutes an optical recording medium such as optical recording disk (CD-RW, DVD-RAM, etc.) whereon signals representing audio, visual and/or text information are reproduced, or recorded, reproduced and erased by means of a laser beam emitted by a semiconductor laser or the like.

### BACKGROUND ART

Reflective layers formed from Ag or Ag alloy are used in optical recording media such as magneto-optical recording disks (MD, MO) and optical recording disks (CD-RW, DVD-RAM). The reflective layers formed from Ag or Ag alloy are preferably used due to high reflectivity for light of broad wavelengths ranging from 400 to 830 nm, and particularly high reflectivity for laser beam having a short wavelength used in high density recording of optical recording media.

As a method for forming the reflective layers from Ag or an Ag alloy, it is known to sputter a target made of Ag or the Ag alloy (refer to Japanese Unexamined Patent Application, First Publication No. Hei 11-213448, Japanese Unexamined Patent Application, First Publication No. 2000-109943, and Japanese Unexamined Patent Application, First Publication No. 2000-57627).

However, among the optical recording media, in those that have recording layer formed from a phase change recording material and are subject to repetitive recording, reproducing and erasing, reflectivity of the reflective layer formed from Ag or Ag alloy decreases as the number of repetitions of recording, reproducing and erasing increases, thus failing to endure repetitive recording and reproducing operations over a long period of time.

### DISCLOSURE OF THE INVENTION

The present inventors have found that one of the causes of the problem described above is that, when recording, reproducing and erasing are carried out repetitively on the optical recording medium, the Ag reflective layer is repetitively heated by the irradiation of laser beam and cooled down, during which the Ag reflective layer recrystallizes to cause the crystal grains to grow into coarse grains that result in lower reflectivity.

Accordingly, the present inventors conducted research into ways to obtain an Ag alloy reflective layer that experiences less decrease in reflectivity of the reflective layer as the number of repetitions of recording, reproducing and erasing increases, and found the following facts:
(a) Growth of the crystal grains into coarse grains through repetitive heating by the irradiation with laser beam and cooling down, and hence the resultant decrease in reflectivity, can be minimized through an extended period of use, by using an Ag alloy reflective layer formed by sputtering a silver alloy target that has a composition of 0.5 to 3% by mass of Cu and 0.1 to 3% by mass in total of one or more elements selected from among Dy, La, Nd, Tb and Gd, with the remainder consisting of Ag;
(b) Growth of the crystal grains into coarse grains through repetitive heating by the irradiation with laser beam and cooling down, and hence the resultant decrease in reflectivity, can be minimized through an extended period of use, by using an Ag alloy reflective layer formed by sputtering a silver alloy target that has a composition of 0.5 to 3% by mass of Cu and 0.005 to 0.05% by mass in total of one or more elements selected from among Ca, Be and Si, with the remainder consisting of Ag;
(c) The same effect can be achieved also by including 0.1 to 3% by mass in total of one or more elements selected from among Dy, La, Nd, Tb and Gd and 0.005 to 0.05% by mass in total of one or more elements selected from among Ca, Be and Si at the same time.

The present invention has been completed based on the research described above, and is characterized by:
(1) A silver alloy sputtering target for forming a reflective layer of optical recording media made of a silver alloy having a composition of 0.5 to 3% by mass of Cu and 0.1 to 3% by mass in total of one or more elements selected from among Dy, La, Nd, Tb and Gd, with the remainder consisting of Ag;
(2) A silver alloy sputtering target for forming a reflective layer of optical recording media made of a silver alloy having a composition of 0.5 to 3% by mass of Cu and 0.005 to 0.05% by mass in total of one or more elements selected from among Ca, Be and Si, with the remainder consisting of Ag;
(3) A silver alloy sputtering target for forming a reflective layer of optical recording media made of a silver alloy having composition of 0.5 to 3% by mass of Cu, 0.1 to 3% by mass in total of one or more elements selected from among Dy, La, Nd, Tb and Gd and 0.005 to 0.05% by mass in total of one or more elements selected from among Ca, Be and Si, with the remainder consisting of Ag.

The sputtering target for forming the silver alloy reflective layer of the present invention can be manufactured by preparing high-purity Ag having purity of 99.99% by mass or higher, and Cu, Dy, La, Nd, Tb and Gd having purity of 99.9% by mass or higher as raw materials, melting these materials in high vacuum or inert gas atmosphere, casting the molten material into an ingot in high vacuum or inert gas atmosphere and machining the ingot after applying hot working.

Ca, Be and Si that hardly form solid solution with Ag are weighed with Ag in such a proportion that concentration of each element is 0.20% by mass. They are melted in a high-frequency vacuum melting furnace and, after melting, with the furnace filled with Ar gas to atmospheric pressure, and cast in a graphite mold to make a mother alloy that includes Ca, Be and Si. The mother alloy and Cu are added into the weighed Ag, melted and cast into an ingot. Then the target can be made by applying hot working and machining it.

Now the reason will be described for setting the composition of the reflective layer made of the Ag alloy according to the present invention and the sputtering target for forming the reflective layer made of the Ag alloy as described above.
Cu:
Cu has the effects of increasing the strength of crystal grains by forming a solid solution with Ag, preventing the crystal grains from recrystallizing, thereby to restrain reflectivity from decreasing. Recrystallization of the crystal grains cannot be prevented satisfactorily and therefore reflectivity cannot be prevented from decreasing, when the Cu content is less than 0.5% by mass. When the Cu content is higher than 3% by mass, on the other hand, initial reflectivity of the Ag alloy reflective layer becomes lower. Accordingly, the Cu content in the Ag alloy reflective layer and in the sputtering target for forming the Ag alloy reflective layer is set within the range from 0.5 to 3% by mass (more preferably from 0.5 to 1.5% by mass).
Dy, La, Nd, Tb, Gd:
These components react with Ag and form intermetallic compounds in the grain boundaries that prevent the crystal grains from agglomerating with each other, thereby preventing the Ag alloy reflective layer from recrystallizing further. Such an effect cannot be significantly achieved when the content of one or more of these elements is less than 0.1% by mass in total. When the content of one or more of these elements is more than 3% by mass in total, on the other hand, the target becomes very hard and difficult to work. Accordingly, the content of these elements in the Ag alloy reflective layer and in the sputtering target for forming the Ag alloy reflective layer is set within the range from 0.1 to 3% by mass (more preferably from 0.2 to 1.5% by mass).
Ca, Be, Si:
These components hardly form solid solution with Ag, and precipitate in the grain boundaries so as to prevent the crystal grains from agglomerating with each other, thereby helping prevent the recrystallization of the Ag alloy reflective layer further. Such an effect cannot be significantly achieved when the content of one or more of these elements is less than 0.005% by mass in total. When the content of one or more of these elements is more than 0.05% by mass in total, on the other hand, the target becomes very hard and difficult to make. Accordingly, the content of these elements in the Ag alloy reflective layer and in the sputtering target for forming the Ag alloy reflective layer is set within the range from 0.005 to 0.05% by mass (more preferably from 0.010 to 0.035% by mass).

### BEST MODE FOR CARRYING OUT THE INVENTION

### Example 1

High-purity Ag having purity of 99.99% by mass or higher, and Cu, Dy, La, Nd, Tb and Gd having purity of 99.9% by mass or higher were prepared as raw materials and were melted in a high-frequency vacuum melting furnace. The molten material was cast into an ingot in a graphite mold in Ar gas atmosphere. The ingot was heated at 600°C for two hours, then rolled and machined thereby to make targets Nos. 1 through 22 of the present invention which dimensions are 125 mm in diameter and 5 mm in thickness and having compositions shown in Tables 1 and 2, comparative targets Nos. 1 through 7 and prior art target.

The targets Nos. 1 through 22 of the present invention, the comparative targets Nos. 1 through 7 and the prior art target, which were bonded onto backing plates made of oxygen-free copper with solder, were then set in a DC magnetron sputtering apparatus. After pumping the inside of the DC magnetron sputtering apparatus to vacuum of 1 × 10⁻⁴ Pa, Ar gas was introduced into the apparatus so as to keep a sputtering gas pressure of 1.0 Pa therein. Then DC sputtering power of 100W was supplied from a DC power source to the target, so as to generate plasma in a space between the target and a glass substrate, which dimensions are 30 mm in diameter and 0.5 mm in thickness and which is disposed to oppose the target in parallel to and with a space of 70 mm from the target, thereby to form the Ag alloy reflective layer having thickness of 100 nm.

Reflectivity of the Ag alloy reflective layer formed as described above was measured with a spectrophotometer immediately after being formed. Then after leaving the Ag alloy reflective layer in a temperature and humidity chamber that was controlled to 80°C in temperature and 85% in relative humidity for 200 hours, reflectivity was measured again under the same conditions. Based on the reflectivity data thus obtained, reflectivity to light was determined for wavelengths 400 nm and 650 nm. The results as shown in Tables 1 and 2 were used to evaluate the durability of the reflective layer as the optical recording medium in recording and reproducing of data.

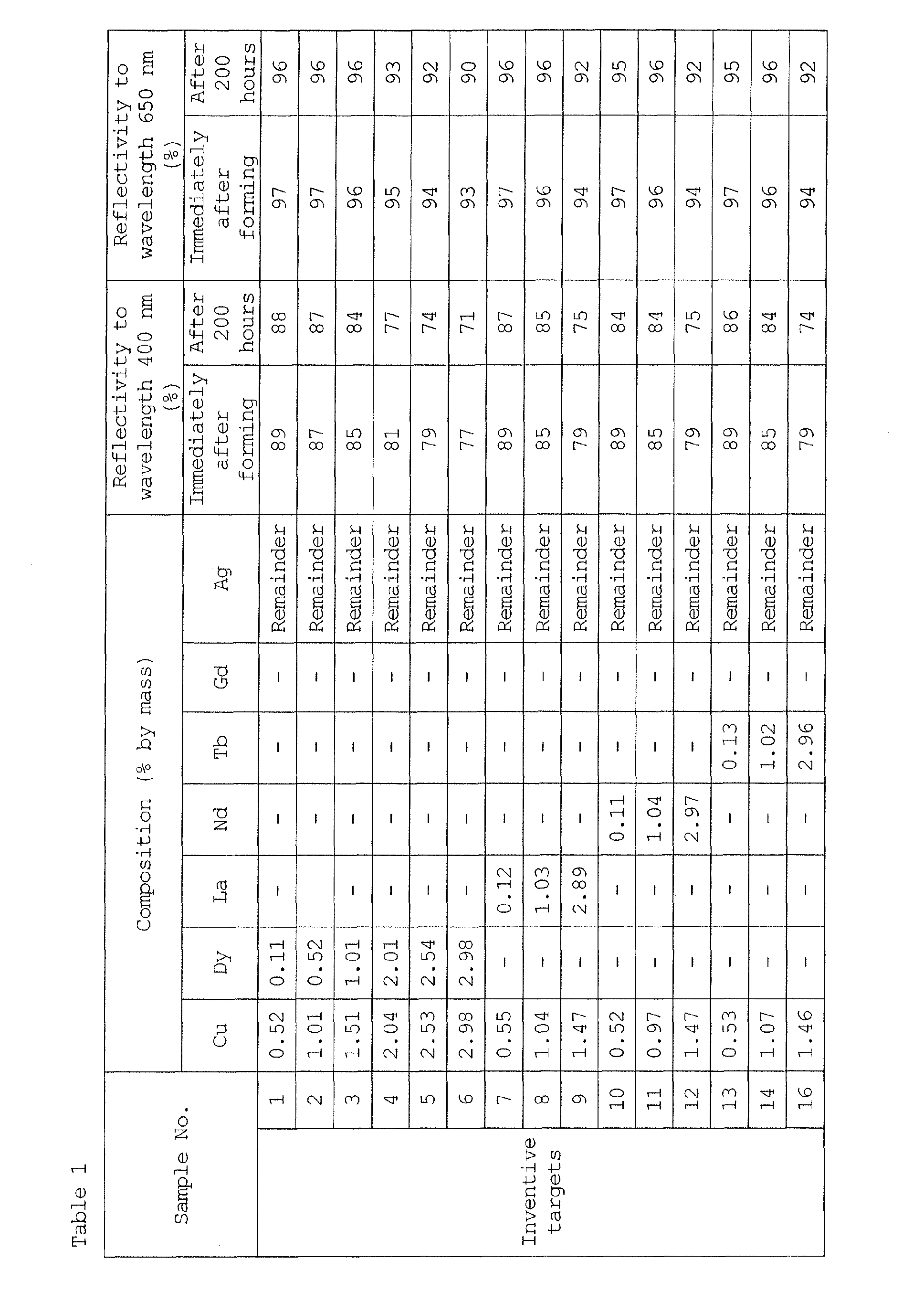

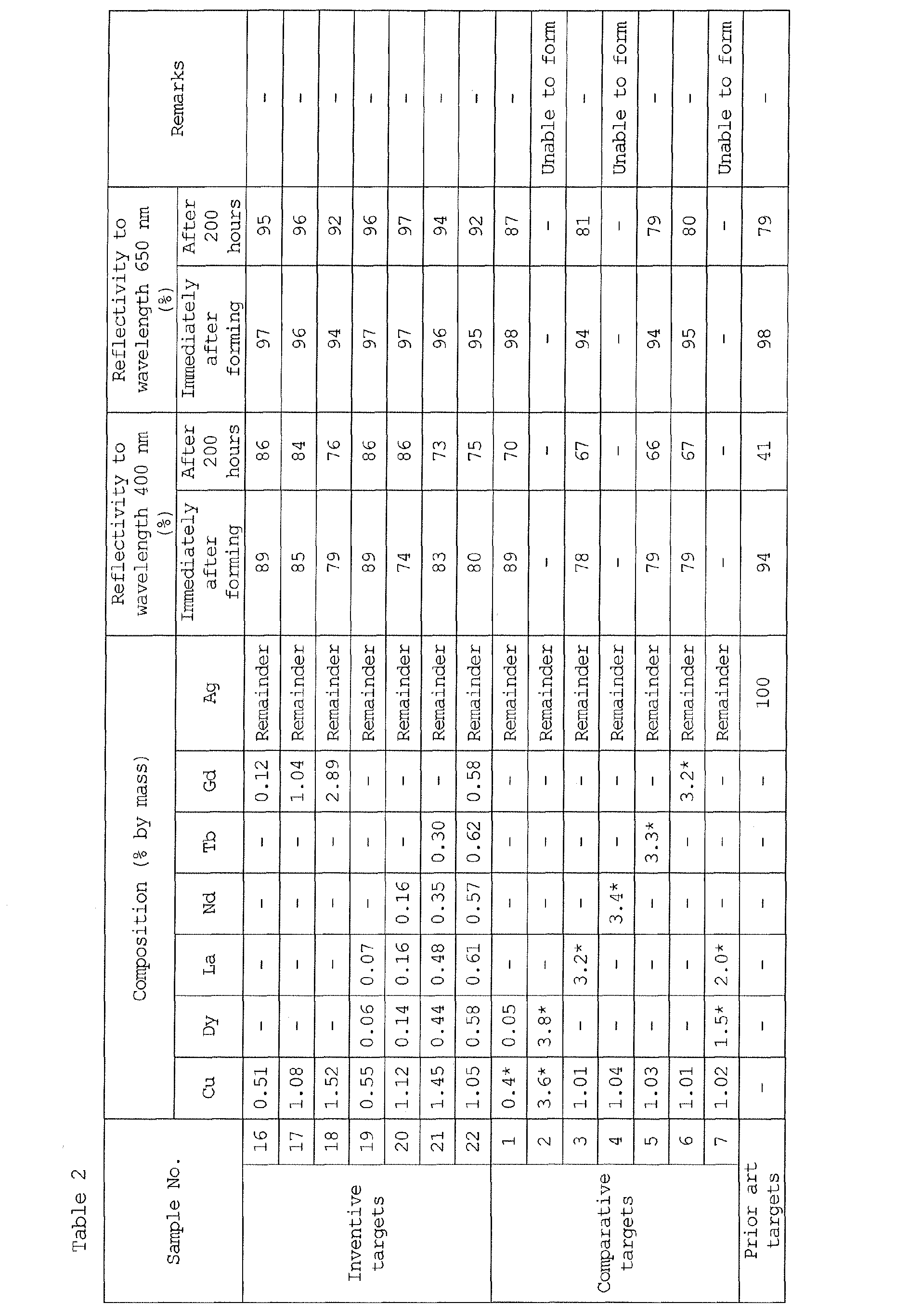

From the results shown in Table 1, it can be seen that the reflective layers formed by sputtering with the targets Nos. 1 through 22 of the present invention experienced less decrease in reflectivity than the reflective layers formed by sputtering with the comparative targets Nos. 1 through 7 or the prior art target, after being left in a temperature and humidity chamber that was controlled to 80°C in temperature and 85% in relative humidity for 200 hours.

### Example 2

Ag, Cu, Ca, Be and Si having purity of 99.99% by mass or higher were prepared as raw materials. Since Ca, Be and Si hardly form solid solution with Ag, these element were weighed with Ag in such a proportion that concentration of each element became 0.20% by mass. They were melted in a high-frequency vacuum melting furnace and, after melting, with the furnace filled with Ar gas to atmospheric pressure, cast in a graphite mold to make a mother alloy that included Ca, Be and Si.

The mother alloy was added together with Cu to Ag, that was then melted and cast into an ingot. The ingot was heated at 600°C for two hours, then rolled and machined thereby to make targets Nos. 23 through 36 of the present invention and comparative targets Nos. 8 through 13 which dimensions were 125 mm in diameter and 5 mm in thickness and having compositions shown in Tables 3 and 4.

The targets Nos. 23 through 36 of the present invention, and the comparative targets Nos. 8 through 13 were used to form the Ag alloy reflective layer having thickness of 100 nm on glass substrate similarly to Example 1. Reflectivity of the Ag alloy reflective layer was measured with a spectrophotometer immediately after being formed. Then after leaving the Ag alloy reflective layer in a temperature and humidity chamber that was controlled to 80°C in temperature and 85% in relative humidity for 200 hours, reflectivity was measured again under the same conditions. Based on the reflectivity data thus obtained, reflectivity to light was determined for wavelengths of 400 nm and 650 nm. The results as shown in Tables 3 and 4 were used to evaluate the durability of the reflective layer as the optical recording medium in recording and reproducing of data.

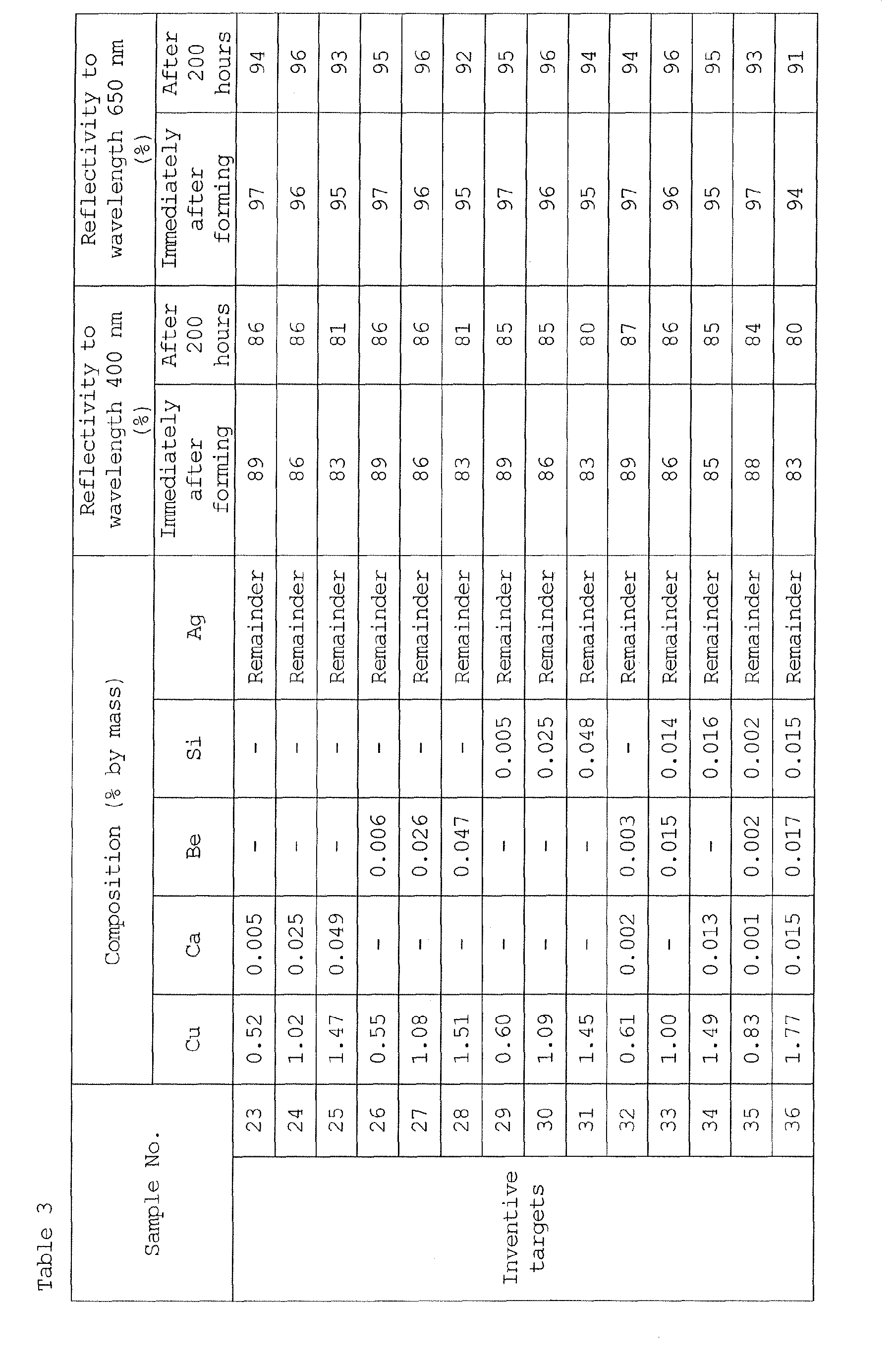

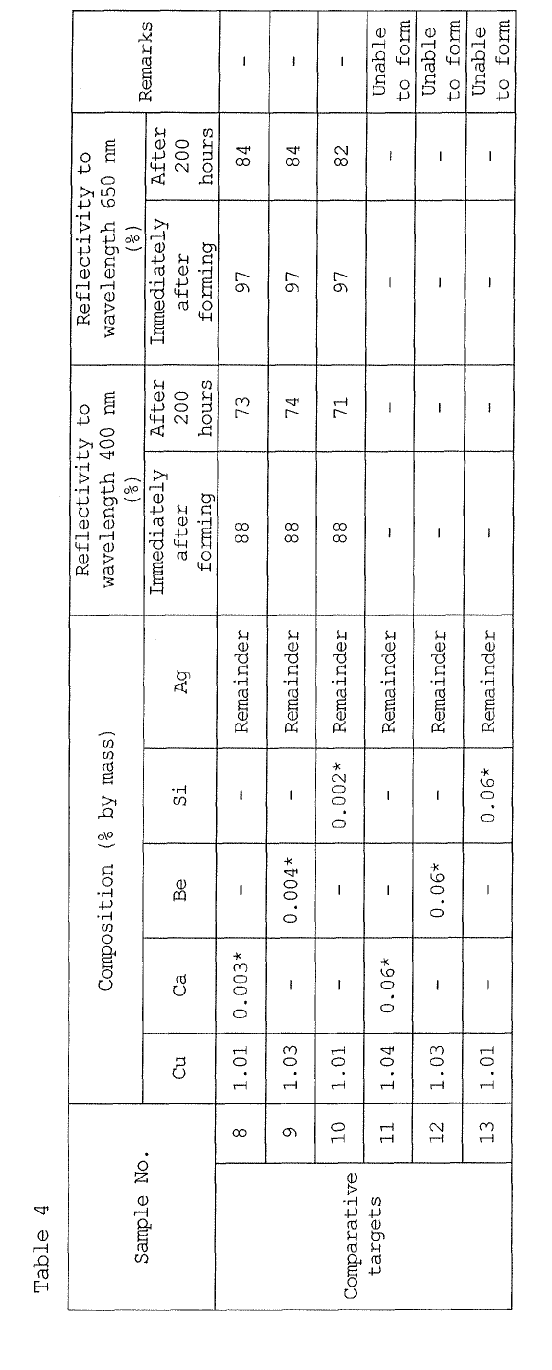

From the results shown in Tables 3 and 4, it can be seen that the reflective layers formed by sputtering with the targets Nos. 23 through 36 of the present invention experienced less decrease in reflectivity than the reflective layers formed by sputtering with the comparative targets Nos. 8 through 13 shown in Table 4 or the prior art target shown in Table 2, after being left in a temperature and humidity chamber that was controlled to 80°C in temperature and 85% in relative humidity for 200 hours.

### Example 3

The raw materials prepared in Example 1 and the mother alloy including Ca, Be and Si prepared in Example 2 were used to make targets Nos. 37 through 50 of the present invention having the compositions shown in Table 5. These targets were used to form the Ag alloy reflective layers having thickness of 100 nm on glass substrate similarly to Example 1. Reflectivity of the Ag alloy reflective layer was measured with a spectrophotometer immediately after being formed. Then after leaving the Ag alloy reflective layer in a temperature and humidity chamber that was controlled to 80°C in temperature and 85% in relative humidity for 200 hours, reflectivity was measured again under the same conditions. Based on the reflectivity data thus obtained, reflectivity to light was determined for wavelengths of 400 nm and 650 nm. The results as shown in Table 5 were used to evaluate the durability of the reflective layer as the optical recording medium in recording and reproducing of data.

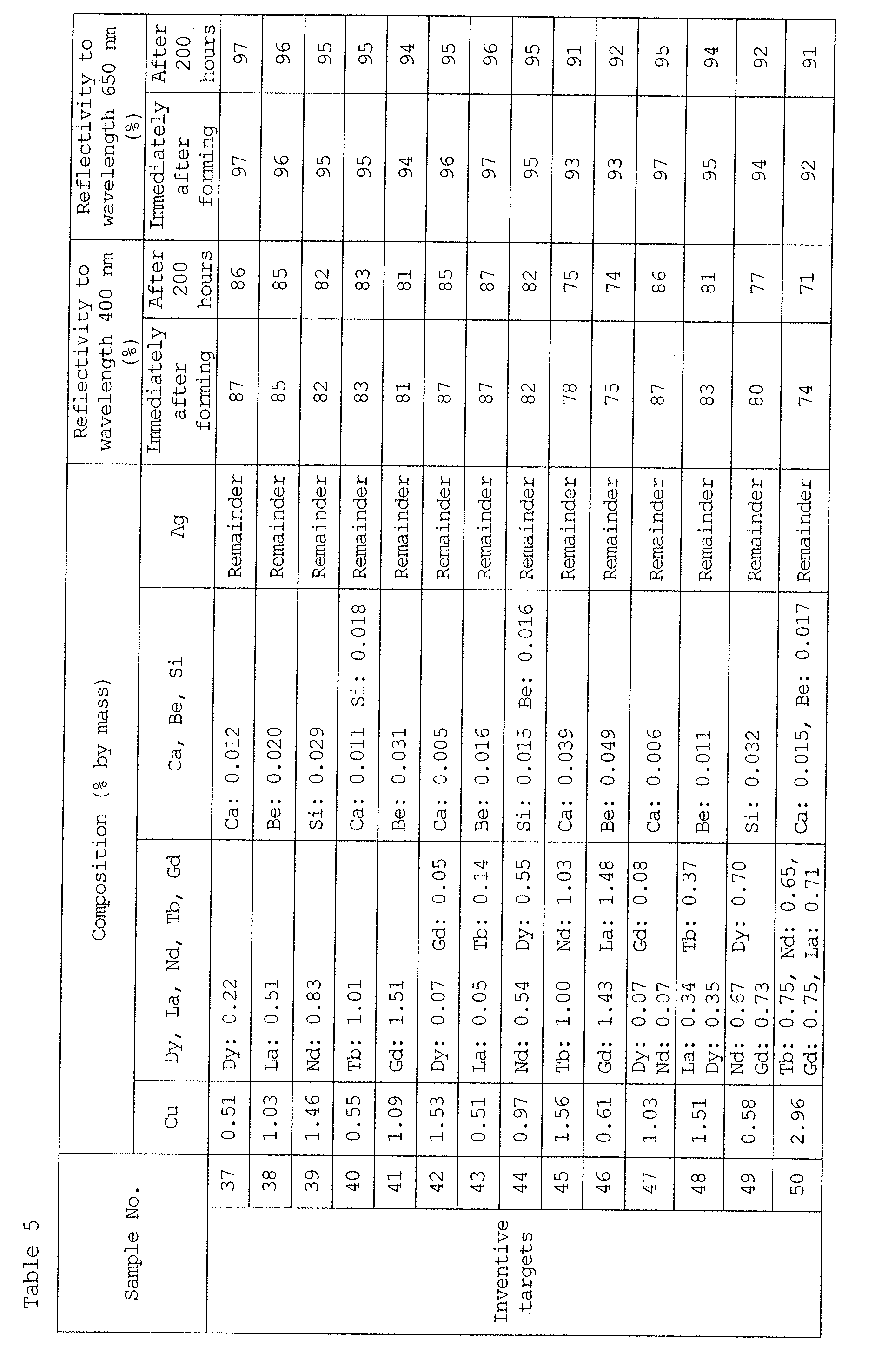

From the results shown in Table 5, it can be seen that the reflective layers formed by sputtering with the targets Nos. 37 through 50 of the present invention experienced less decrease in reflectivity for wavelengths of 400 nm and 650 nm than the reflective layers formed by sputtering with the comparative targets Nos. 1 through 7 shown in Table 2, the prior art target or the comparative targets Nos.8 through 13 shown in Table 4, after being left in a temperature and humidity chamber that was controlled to 80°C in temperature and 85% in relative humidity for 200 hours.

### INDUSTRIAL APPLICABILITY

The reflective layer formed by using the silver alloy sputtering target for forming a reflective layer of optical recording media according to the present invention experiences less decrease in reflectivity caused by aging than the reflective layer formed by using the silver alloy sputtering target for forming a reflective layer of optical recording media of the prior art does, and makes it possible to manufacture optical recording media that can be used over an extended period of time, so as to make great contribution to the development of the recording media industry.

## Claims

1. A silver alloy sputtering target for forming a reflective layer of optical recording media comprising:
a silver alloy having a composition of
0.5 to 3% by mass of Cu;
0.1 to 3% by mass in total of one or more elements selected from among Dy, La, Nd, Tb and Gd; and
the remainder consisting of Ag.

2. A silver alloy sputtering target for forming a reflective layer of optical recording media comprising:
a silver alloy having a composition of
0.5 to 3% by mass of Cu;
0.005 to 0.05% by mass in total of one or more elements selected from among Ca, Be and Si; and
the remainder consisting of Ag.

3. A silver alloy sputtering target for forming a reflective layer of optical recording media comprising:
a silver alloy having a composition of
0.5 to 3% by mass of Cu;
0.1 to 3% by mass in total of one or more elements selected from among Dy, La, Nd, Tb and Gd;
0.005 to 0.05% by mass in total of one or more elements selected from among Ca, Be and Si; and
the remainder consisting of Ag.

4. A reflective layer of optical recording medium formed by using the silver alloy sputtering target according to claim 1, 2 or 3.
